Europäisches Patentamt

European Patent Office

Office européen des brevets

(19)

(11) EP 0 701 392 B1

## (12) FASCICULE DE BREVET EUROPEEN

(45) Date de publication et mention
de la délivrance du brevet:
**15.04.1998 Bulletin 1998/16**

(51) Int Cl.6: **H05H 1/46**, H01Q 1/36,
H01Q 9/30, H01J 9/02

(21) Numéro de dépôt: **95402002.0**

(22) Date de dépôt: **04.09.1995**

(54) **Antenne cylindrique utilisable pour générer un plasma dans les conditions de résonance cyclotronique électronique**

Zylinderantenne verwendbar zur Erzeugung eines Plasmas unter den Bedingungen von
Elektronzyklotronresonanz

Cylindrical antenna usable for generating a plasma under electron cyclotron resonance conditions

(84) Etats contractants désignés:
**CH DE FR GB LI**

(30) Priorité: **06.09.1994 FR 9410646**
**26.06.1995 WOPCT/FR95/00849**

(43) Date de publication de la demande:
**13.03.1996 Bulletin 1996/11**

(73) Titulaires:
- **COMMISSARIAT A L'ENERGIE ATOMIQUE**
 **75015 Paris Cédex 15 (FR)**
- **ETAT FRANCAIS**
 **Représenté par le délégué général pour**
 **l'armement**
 **F-00460 Armées (FR)**

(72) Inventeurs:
- **Perrin, Aimé**
 **F-38330 Saint Ismier (FR)**
- **Rolland, Bernard**
 **F-38240 Meylan (FR)**

(74) Mandataire: **Dubois-Chabert, Guy et al**
**c/o BREVATOME**
**25, rue de Ponthieu**
**75008 Paris (FR)**

(56) Documents cités:
EP-A- 0 448 077          EP-A- 0 613 329
US-A- 3 238 531

- **PATENT ABSTRACTS OF JAPAN vol. 18, no. 116 (E-1515) 24 Février 1994 & JP-A-05 314 918 (NISSIN ELECTRIC) 26 Novembre 1993**

## Description

### Domaine technique

La présente invention concerne le domaine technique général de la génération d'un plasma dans un milieu gazeux à partir d'une excitation micro-onde, en particulier par résonance cyclotronique-électronique (RCE).

Pour avoir cette résonance, le champ magnétique B et la fréquence d'excitation f du champ électrique sont reliés par la relation $B = \frac{2\pi m f}{e}$, où m et e sont respectivement la masse et la charge de l'électron. Par exemple, pour une fréquence de 2,45 GHz, le champ magnétique est de $875.10^{-4}$T.

Le transfert d'énergie est maximum lorsque le champ électrique d'excitation est perpendiculaire au champ magnétique.

### Etat de la technique antérieure

Actuellement, l'introduction de l'énergie micro-onde dans une enceinte à plasma se fait de différentes façons.

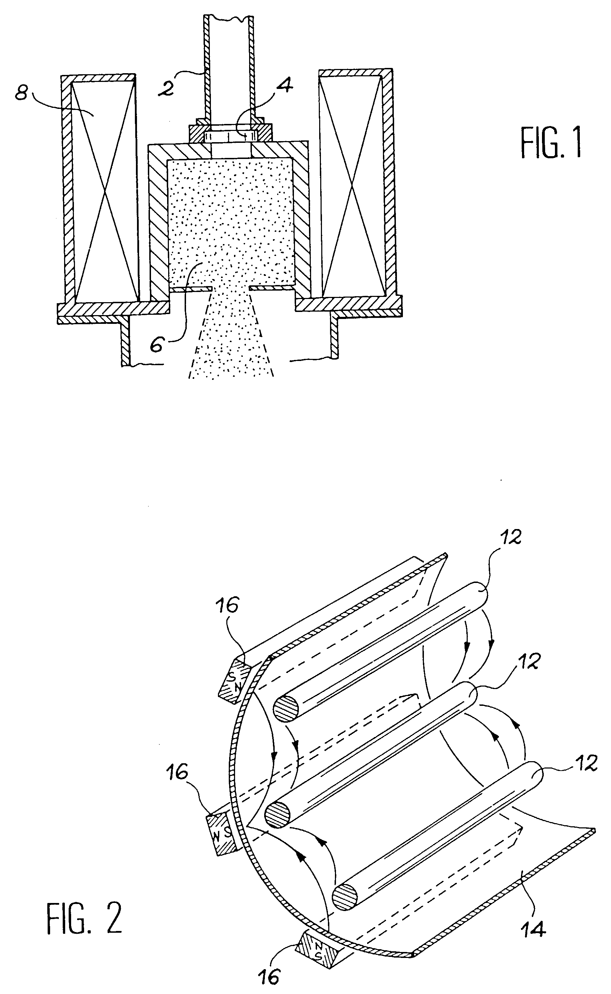

Une première méthode consiste, comme illustré sur la figure 1, à faire arriver de l'énergie micro-onde dans un guide d'onde 2, cette énergie passant ensuite par une fenêtre 4 et étant ensuite transmise dans la zone d'utilisation 6. Dans cette zone 6, le champ excitateur micro-onde, injecté de la façon décrite ci-dessus, est combiné à un champ magnétique fourni en général par des bobines 8, qui permet d'avoir les conditions de résonance RCE. Dans ce type de système, l'utilisation d'une fenêtre 4 peut être contraignante, car, suivant l'application envisagée, cette fenêtre peut se recouvrir d'un dépôt métallique qui empêche l'introduction des micro-ondes. De plus ce système, avec ses bobines 8 est relativement encombrant et, de ce fait, d'utilisation peu souple. Pratiquement, il ne peut être utilisé que sur une enceinte conçue pour le recevoir.

Selon une autre méthode, illustrée sur la figure 2, l'énergie micro-onde est introduire par des antennes 12 réparties le long des parois d'une enceinte 14. Des aimants 16, qui fournissent le champ magnétique nécessaire à la RCE sont placés à l'extérieur de l'enceinte et en regard des antennes. Leur polarité est indiquée sur la figure 2. Dans ce système, les antennes 12, pour être dans la zone où le champ magnétique vaut environ $875.10^{-4}$T, devront être proches des parois de l'enceinte 14. De plus, étant donné la position des pôles des aimants, les lignes de champ magnétique sont dans un plan perpendiculaire à l'axe des antennes. Il apparaît donc un courant de dérive dans le plasma, la direction de ce courant étant perpendiculaire au plan contenant les lignes de champ magnétique, donc parallèle à l'antenne. Il s'ensuit un plasma inhomogène le long de l'antenne, plus dense à l'une des extrémités.

Un autre dispositif est connu du document japonais JP-5 314 918. Ce document décrit une antenne cylindrique comportant quatre aimants régulièrement répartis autour d'un circuit de circulation d'un fluide de refroidissement. Mais, là encore, les lignes de champ sont perpendiculaires à l'axe de l'antenne et on constate donc la même dérive de courant de diffusion, parallèlement à l'antenne.

### Exposé de l'invention

Le but de l'invention est donc de proposer un dispositif d'excitation autonome, facilement intégrable dans une enceinte pour générer un plasma dans les conditions de résonance cyclotronique-électronique, permettant de résoudre les problèmes exposés ci-dessus.

L'invention a donc pour objet une antenne micro-onde comportant au moins une portion cylindrique creuse, contenant des moyens pour générer un champ magnétique au voisinage de l'antenne, et caractérisée en ce que les lignes du champ magnétique engendré sont essentiellement dans des plans parallèles aux génératrices de la portion cylindrique.

Avec une telle structure d'antenne, le courant de dérive du plasma est à chaque instant dans un plan perpendiculaire aux génératrices du cylindre. Ce courant va donc décrire une trajectoire centrée sur l'antenne, ce qui n'entraîne aucune inhomogénéité dans le plasma, au contraire de ce qui se produit dans les dispositifs selon l'art antérieur.

Selon un mode particulier de réalisation de cette invention, les moyens pour générer le champ magnétique sont constitués par un empilement d'aimants cylindriques, chaque extrémité de chaque aimant étant en regard d'une extrémité de même polarité d'un aimant immédiatement voisin.

De façon alternative, on peut remplacer les aimants par des bobines.

Selon un autre mode particulier de réalisation de l'invention, l'antenne comporte deux portions cylindriques creuses parallèles, chacune contenant des moyens pour générer un champ magnétique au voisinage de l'antenne, les lignes de champ magnétique étant essentiellement dans des plans passant par l'axe de chaque portion cylindrique.

On obtient ainsi, selon cet autre mode de réalisation, une structure d'antenne en forme d'épingle.

L'invention a plus généralement pour objet une antenne micro-onde caractérisée en ce qu'elle comporte au moins une portion tubulaire présentant un axe central, des aimants, ou bien des bobines électromagnétiques, étant disposé(e)s à l'intérieur de la portion tubulaire, le long de l'axe central, ces aimants, ou bien ces bobines, engendrant un champ magnétique au voisinage de l'antenne, chaque extrémité de chaque aimant étant en regard d'une extrémité de même polarité d'un aimant immédiatement voisin, ou bien l'enroulement de chaque bobine étant tel que, lorsque la bobine est activée, chacune de ses extrémités est en regard d'une extrémité de même polarité d'une bobine immédiatement voisine. Le fil des bobines peut être supraconducteur.

Ce type d'antenne, et en particulier, la disposition relative des moyens magnétiques dans l'antenne, permet également d'obtenir un courant de dérive du plasma décrivant une trajectoire centrée sur l'antenne ; ceci n'entraîne aucune inhomogénéité dans le plasma, au contraire de ce qui se produit dans l'art antérieur.

Selon un mode particulier de réalisation, la portion tubulaire peut être une portion cylindrique creuse, les aimants, ou les bobines, étant empilés dans cette portion cylindrique creuse, et les lignes du champ magnétique engendré étant alors essentiellement dans des plans parallèles aux génératrices de la portion cylindrique. Une telle antenne peut en outre comporter au moins deux portions cylindriques creuses, chacune contenant des moyens pour générer un champ magnétique au voisinage de l'antenne, les lignes du champ magnétique engendré au voisinage de chaque portion étant essentiellement dans des plans parallèles aux génératrices de ladite portion cylindrique.

Selon un autre mode de réalisation, la portion tubulaire peut avoir la forme d'un anneau, ou d'un tore ou d'une boucle. La portion tubulaire peut également être disposée suivant une hélice.

Dans tous les cas, des moyens peuvent être prévus pour assurer la circulation d'un fluide caloporteur.

L'invention concerne également un procédé de réalisation de micropointes, qui met en oeuvre au moins une antenne telle que décrite ci-dessus.

Des écrans à micropointes sont utilisés dans la réalisation de dispositifs d'affichage, pour lesquels on souhaite obtenir des dimensions de plus en plus importantes (par exemple une dimension de diagonale de l'écran de 15, 20 ou 30 pouces ou plus encore, un pouce étant égal à 2,54 cm). Il faut donc arriver à réaliser des trous de très petits diamètres sur de grandes surfaces.

Actuellement la fabrication de micropointes, d'une manière générale, et de micropointes pour écrans plats, en particulier, s'effectue par évaporation sous vide.

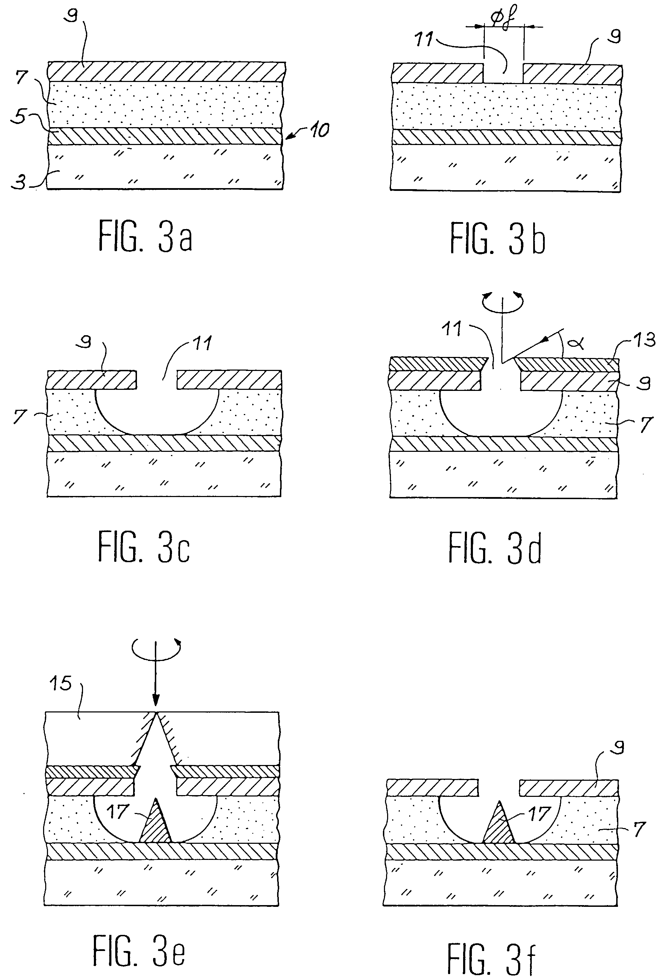

Les figures 3a à 3f représentent les différentes étapes d'un procédé de réalisation d'une source d'électrons à micropointes par évaporation sous vide. Un tel procédé est décrit, par exemple, dans le document FR-A-2 593 953 (brevet américain correspondant : US-A-4 857 161). Ce procédé comporte les étapes suivantes, numérotées 1 à 9 :

1)- dépôt par pulvérisation cathodique sur un substrat en verre 3, d'une couche d'oxyde de silicium (non représentée sur la figure), d'environ 100 nm ;
2)- dépôt par pulvérisation cathodique, sur cette couche, d'une première couche conductrice en oxyde d'indium dans laquelle seront réalisés les conducteurs cathodiques 5 (épaisseur environ 160 nm) ;
3)- gravure de la première couche conductrice pour former des premières bandes conductrices parallèles ou conducteurs cathodiques 5 ;
4)- dépôt chimique en phase vapeur (à partir des gaz de silane, phosphine, oxygène) d'une couche isolante 7 d'oxyde de silicium d'épaisseur environ 1 $\mu m$ ;
5)- dépôt par évaporation sous vide, sur la couche d'oxyde de silicium, d'une couche conductrice 9, dans laquelle seront formées les grilles (niobium, épaisseur environ 0,4 $\mu m$) ;
6)- ouverture de trous 11 de diamètre $\phi_f$ dans cette couche conductrice 9, par gravure ionique réactive (GIR) en utilisant un plasma de $SF_6$ (figure 3b), et dans la couche 7 (figure 3c) par gravure ionique réactive dans un plasma de $CHF_3$ ou par attaque chimique dans une solution d'acide fluorhydrique et de fluorure d'ammonium ;
7)- dépôt d'une couche de nickel 13 (figure 3d) par évaporation sous vide, sous incidence rasante par rapport à la surface de la structure. L'angle a formé entre l'axe d'évaporation et la surface de la couche est voisin de 15°. La couche de nickel présente une épaisseur d'environ 150 nm ;
8)- formation des micropointes par dépôt d'une couche en molybdène 15 sur l'ensemble de la structure (figure 3e). Cette couche 15 présente une épaisseur d'environ 1,8 $\mu m$. Elle est déposée sous incidence normale par rapport à la surface de la structure ; cette technique de dépôt permet d'obtenir des cônes 17 en molybdène logés dans les trous 11 ayant une hauteur de 1,2 à 1,5 $\mu m$ ;
9)- dissolution sélective de la couche de nickel 13 par un procédé électrochimique de façon à dégager, comme représenté sur la figure 3f, les grilles en niobium 9 perforées et à faire apparaître les micropointes 17 émettrices d'électrons.

Cette technique présente un certain nombre d'inconvénients.

Tout d'abord, la réalisation par la technique d'évaporation sous vide, de micropointes sur des surfaces de très grandes dimensions est actuellement impossible à réaliser : on ne réalise à l'heure actuelle par exemple des dépôts que sur des écrans de 6 pouces (15 cm) de diagonale.

De plus, il est difficile d'obtenir des pointes de composition contrôlée et stable (par exemple : carbures, nitrures, ...).

L'introduction de gaz réactifs dans l'enceinte ne permet pas la réalisation de dépôts à composition contrôlée à cause de l'impossibilité d'avoir des flux constants de matière évaporée en un temps de dépôt donné. D'autre part, en évaporation, il est très difficile d'obtenir la composition du revêtement équivalente à celle des matériaux à évaporer dès lors que l'on veut évaporer des matériaux type MCx, MNx et MOc (M=métal, C=carbone, N=azote et x étant le rapport stoechiométrique). Des matériaux comme le carbone de type diamant sont également impossible à élaborer.

Une demande de brevet européen EP-A-0 564 028 décrit un procédé de fabrication d'électrodes en pointe en utilisant un dépôt par pulvérisation cathodique dirigée au moyen d'un filtre de collimation, composé par exemple d'un ensemble d'éléments tubulaires parallèles entre eux, ce qui permet d'obtenir un flux de particules ayant une faible déviation par rapport à la direction perpendiculaire au substrat.

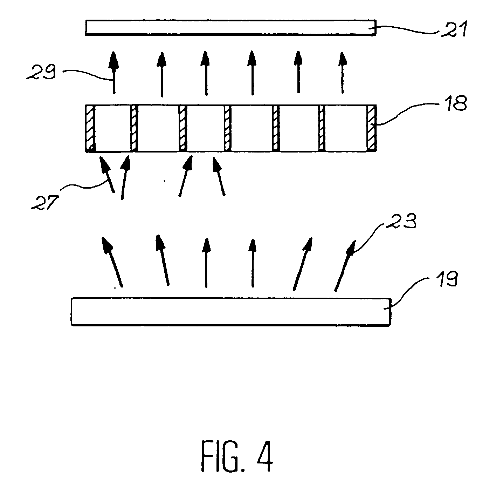

Dans cette demande, et comme illustré sur la figure 4, un système de canalisation 18 de la vapeur est intercalé entre le dispositif de pulvérisation cathodique 19 et le substrat 21, le flux de vapeur étant représenté par les flèches 23. Les flèches 27 représentent la vapeur incidente sur le système de canalisation, et les flèches 29 la vapeur canalisée. Les atomes émis par le dispositif de pulvérisation non alignés avec le système de canalisation se déposent sur les parois du système de canalisation. Ce système permet donc d'avoir un flux directif. Cependant, il provoque une diminution importante du rendement de fabrication de micropointes, une grande partie de la matière étant déposée sur les parois du système de canalisation.

Pour résoudre ces différents problèmes des dispositifs et procédés de l'art connu, le procédé selon l'invention permet l'élaboration de micropointes à composition contrôlée sur grandes surfaces, avec des vitesses de dépôt élevées et un bon contrôle du flux de vapeur (possibilité de faire des dépôts homogènes en épaisseur) ; en outre, ce procédé permet de réaliser des dépôts en "réactif".

Plus précisément, l'invention a pour objet un procédé d'élaboration de micropointes, à composition contrôlée, sur de grandes surfaces, utilisant une technique de pulvérisation cathodique de type magnétron, une décharge micro-onde, produite par une ou plusieurs antennes micro-ondes telles que déjà décrites ci-dessus, générant et entretenant un plasma basse pression, permettant d'envoyer des électrons à la surface du magnétron.

Dans le procédé selon l'invention, pour obtenir des vitesses de dépôt élevées, un bon contrôle du flux de vapeur, et la possibilité de faire des dépôts en réactifs, on a été conduit à choisir la pulvérisation cathodique magnétron. Cette technique est utilisable pour des pressions de l'ordre de $2.10^{-3}$ mbar à $5.10^{-2}$ mbar pendant la phase de dépôt. Or, ces pressions ne permettent pas, suite à la valeur du libre parcours moyen, d'avoir des flux de vapeur directifs qui permettent d'élaborer des pointes dans des cavités. De plus, dans le domaine considéré, la technique d'évaporation sous vide était connue, comme la seule pouvant permettre cette réalisation en particulier parce qu'elle présente un flux directif, ce qui n'est pas le cas dans la technique magnétron.

Le procédé selon l'invention permet de réaliser un système d'assistance du magnétron par décharges micro-ondes, à l'aide d'une antenne selon l'invention. Dans ces conditions, le flux de vapeur est plus directif : le libre parcours moyen est de l'ordre du mètre.

Puisqu'on utilise une antenne selon l'invention, le courant de dérive du plasma décrit une trajectoire centrée sur l'antenne ou sur chacune des antennes.

Le plasma est donc sans inhomogénéités, conformément à ce qui a déjà été dit ci-dessus.

Dans le procédé de l'invention, on peut utiliser des cibles de composition souhaitée, ou réaliser des dépôts en mode réactif.

Ce procédé est donc une technique de dépôt de micropointes, par exemple pour applications aux écrans plats, en remplacement de la technique d'évaporation.

Ce procédé permet l'obtention de micropointes sur de grandes surfaces. Le traitement au "défilé" pour ces techniques est possible.

Ce procédé permet l'obtention de micropointes à compositions contrôlées impossibles à obtenir en évaporation. Ces compositions peuvent être :

- des métaux purs ;
- des composés métal-carbone MCx :

    * solutions sursaturées de carbone dans le métal par exemple : MoCx, CrCx, TiCx
    * carbures intermédiaires : $Mo_2C$, $Ti_2C$
    * carbures supérieurs : MoC TiC...
    * carbures + carbone libre MoC + C, $Mo_2CL$ ;

- des composés métal-azote

    * MNx par exemple : TiNx
        MoNx
        CrNx
    * nitrures : $Ti_2N$
        $Mo_2N$
        TiN
        MoN

Brève description des figures

De toute façon, les caractéristiques et avantages de l'invention apparaîtront mieux à la lumière de la description qui va suivre. Cette description porte sur les exemples de réalisation, donnés à. titre explicatif et non limitatif, en se référant à des dessins annexés sur lesquels :

- les figures 1 et 2, déjà décrites, représentent des dispositifs générateurs de plasma, selon l'art antérieur,
- Les figures 3a à 3f représentent les différentes étapes d'un procédé de fabrication d'une source d'électrons à micropointes selon l'art antérieur ;
- la figure 4 illustre une autre réalisation de l'art connu;
- la figure 5 représente la structure d'une antenne selon l'invention,
- la figure 6 représente une antenne selon l'invention, avec son système de raccordement à une alimentation électrique micro-onde,

- les figures 7a et 7b représentent deux antennes rectilignes selon l'invention, avec deux circuits différents pour la circulation d'un fluide caloporteur,
- la figure 8 représente une structure d'antenne selon l'invention, en forme d'épingle,
- les figures 9, 10A et 10B représentent d'autres variantes de l'invention,
- les figures 11 et 12 illustrent deux exemples de réalisation du procédé de fabrication des micropointes selon l'invention, respectivement dans une vue de côté (figures 11a et 12a) et dans une vue de dessus (figures 11b et 12b).

Description détaillée de modes de réalisation de l'invention

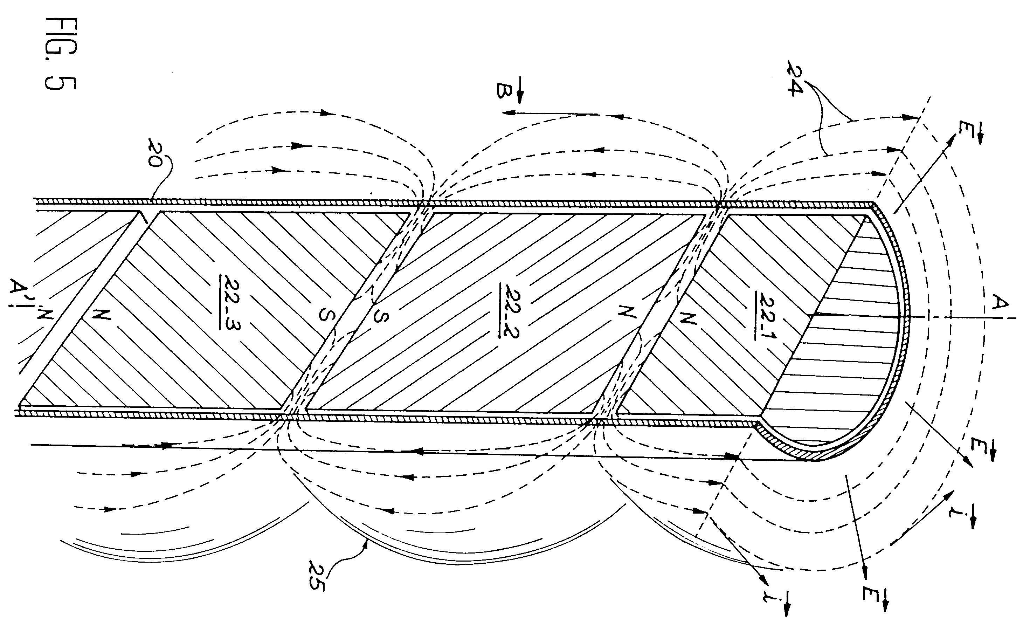

La figure 5 représente un exemple d'une structure d'antenne selon l'invention. L'antenne a la forme d'un cylindre creux 20 de révolution, avec un axe de symétrie AA', à l'intérieur duquel sont disposés des aimants 22-1, 22-2, 22-3, ..., de forme également cylindrique. Chaque aimant est séparé de chacun de ses voisins par une distance de l'ordre de, par exemple, quelques millimètres ; la séparation est assurée, par exemple, par une petite cale en un matériau amagnétique. Les pôles de ces aimants sont sur des faces planes perpendiculaires à l'axe du cylindre, et les aimants sont empilés de façon à ce que les pôles en regard de deux aimants immédiatement voisins (par exemple 22-1 et 22-2) soient de même signe. Cette structure donne, ainsi qu'illustré sur la figure 5, une configuration de champs magnétiques en chevrons toriques qui entourent l'antenne, les lignes de champ 24 étant dans ou essentiellement dans des plans passant par l'axe de l'antenne. Le fait de mettre les aimants dans l'antenne a pour conséquence que celle-ci se trouve immédiatement dans la zone où l'intensité du champ magnétique est favorable à la résonance cyclotronique-électronique. D'autre part, le champ électrique $\vec{E}$ étant radial, cette zone de résonance est constituée d'anneaux 25 entourant l'antenne. Par conséquent, le volume de l'espace où a lieu la résonance est supérieur au volume obtenu avec les dispositifs selon l'art antérieur. En outre, les champs magnétique $\vec{B}$ et électrique $\vec{E}$ sont essentiellement perpendiculaires entre eux et le transfert d'énergie est donc maximum dans ce volume.

De plus, les lignes de champ magnétique étant dans des plans passant par l'axe de l'antenne, le courant de dérive $\vec{i}$ du plasma est à chaque instant perpendiculaire à un tel plan, comme illustré sur la figure 5. Ce courant va donc décrire un cercle centré sur l'antenne, ce qui n'entraîne aucune inhomogénéité dans le plasma.

L'antenne de la figure 5 a la forme d'un cylindre de révolution et présente un axe de symétrie AA'. Mais il est clair que l'invention peut être appliquée à une antenne ne présentant pas une telle symétrie. Dans un cylindre de section quelconque, un empilement d'aimants respectant l'ordre des polarités indiqué ci-dessus peut être introduit, les aimants ayant une forme adaptée à la section du cylindre. Les lignes de champ magnétique sont alors contenues dans des plans parallèles aux génératrices du cylindre. Dans ce cas, comme dans le précédent, l'antenne se trouve donc encore dans la zone où l'intensité du champ magnétique est favorable à la résonance cyclotronique-électronique, la zone de résonance est encore constituée d'anneaux entourant l'antenne, et les champs $\vec{B}$ et $\vec{E}$ sont toujours essentiellement perpendiculaires entre eux.

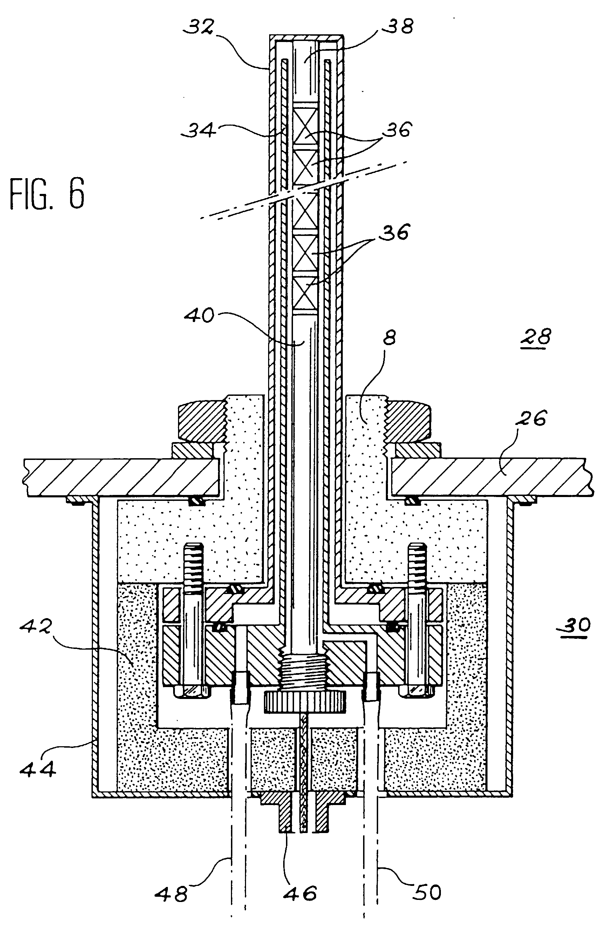

L'antenne comporte également un système de raccordement à une alimentation électrique micro-onde. Ce système de raccordement peut être un passage coaxial, ainsi qu'illustré sur la figure 6, qui représente l'ensemble de l'antenne. De façon plus détaillée, la référence 26 désigne une paroi d'une enceinte séparant la zone de travail 28 (où les champs électrique et magnétique sont induits) de la zone extérieure 30. L'antenne comprend un tube extérieur 32 et un tube intérieur 34, dans lequel des aimants 36 sont empilés de la façon déjà décrite ci-dessus, deux cales 38 et 40 délimitant, de chaque côté, leur zone d'extension. Une pièce isolante 42 assure l'étanchéité entre l'intérieur 28 et l'extérieur 30 de l'enceinte. Les références 42 et 44 désignent respectivement un capot isolant et un capot conducteur relié à la masse. La prise coaxiale 46 assure la connexion à une alimentation électrique micro-onde. Les références 48 et 50 désignent des tubes isolants d'entrée et de sortie d'un circuit de refroidissement, qui permettent la circulation d'un fluide caloporteur (par exemple de l'eau).

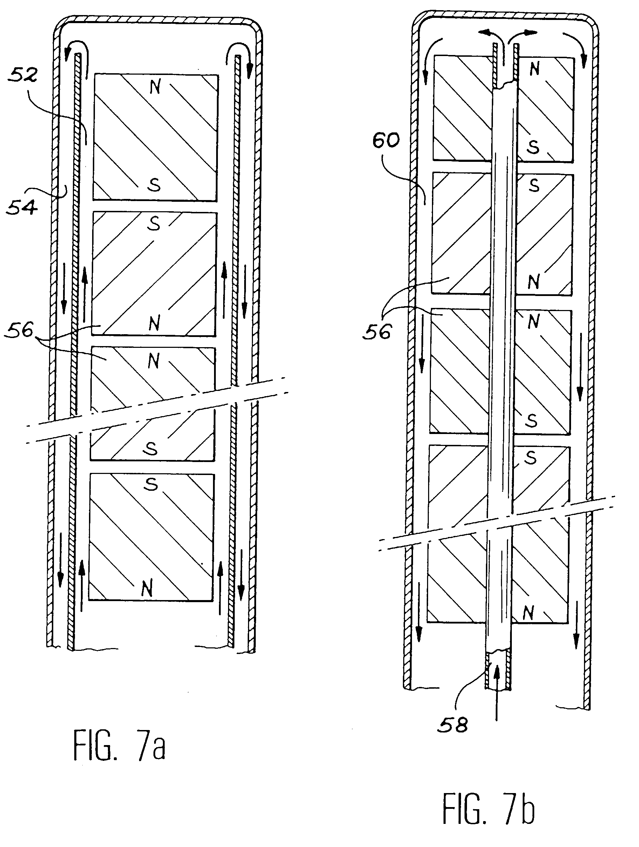

Les figures 7a et 7b représentent deux variantes possible du circuit de refroidissement.

Sur la figure 7a le circuit de refroidissement est constitué d'une double enveloppe périphérique 52, 54. Le fluide se propage selon un trajet parallèle à l'axe du cylindre (ou, plus généralement, aux génératrices du cylindre), le long des aimants 56, et revient ensuite en sens inverse, toujours parallèlement à l'axe du cylindre (ou aux génératrices du cylindre). Dans la variante de la figure 7b, les aimants 56 ont été percés suivant l'axe du cylindre (ou, plus généralement, parallèlement aux génératrices du cylindre), ce qui permet l'introduction d'un tube cylindrique 58, par lequel est introduit le fluide caloporteur. Arrivé à l'extrémité supérieure de l'empilement des aimants, le fluide revient selon un trajet toujours parallèle à l'axe du cylindre (ou aux génératrices du cylindre), mais en longeant la partie périphérique 60 des aimants.

Selon une variante, les aimants peuvent être remplacés par des bobines, le matériau constituant le fil des bobines pouvant être supraconducteur. L'enroulement de chaque bobine est tel que, lorsque la bobine est activée, chacune de ses extrémité est en regard d'une extrémité de même polarité d'une bobine immédiatement voisine.

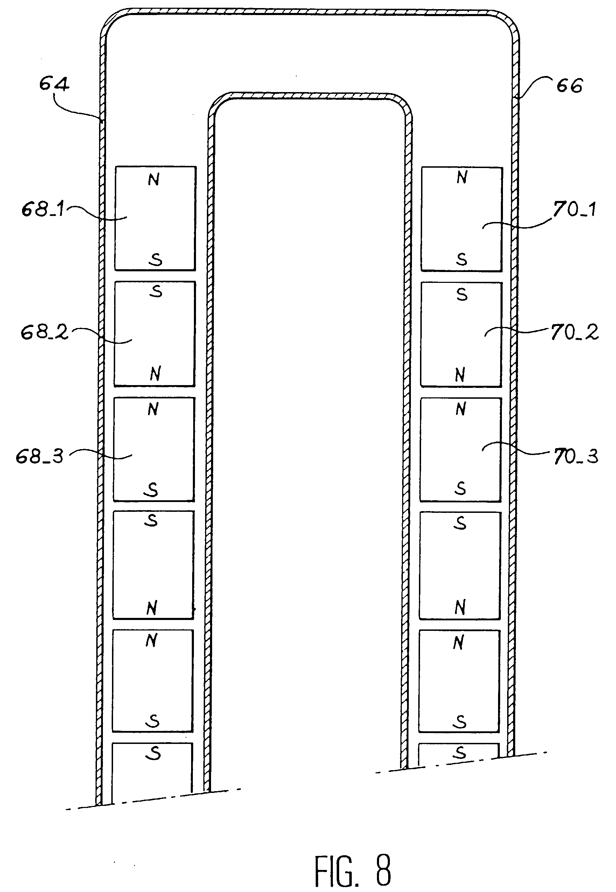

Selon un autre mode de réalisation de l'invention, l'antenne comporte deux branches 64, 66 reliées par une de leurs extrémités, et se présente par exemple sous forme d'une épingle comme illustré sur la figure 8. Dans chacune des branches, on trouve un empilement d'aimants cylindriques 68-1, 68-2, .... 70-1, 70-2, ..., la polarité des aimants dans chaque branche de l'épingle étant orientée de la façon décrite ci-dessus. De préférence, les aimants (par exemple 68-1, 70-1) se faisant face dans chacune des branches de l'épingle ont des polarités orientées dans le même sens. Une extrémité d'une branche est raccordée au générateur, l'extrémité de l'autre branche est à la masse.

Plus généralement, des branches de formes plus complexes peuvent être réalisées (en escalier, en "V", ...etc.), l'antenne comportant alors au moins deux portions cylindriques creusées, chacune contenant des moyens pour générer un champ magnétique au voisinage de l'antenne, les lignes du champ magnétique engendré au voisinage de chaque portion étant dans ou essentiellement dans des plans parallèles aux génératrices de ladite portion cylindrique.

Suivant un exemple, une antenne a été réalisée, constituée d'un tube de cuivre, d'un diamètre de 25 mm, dans lequel on a empilé dix aimants cylindriques disposés en opposition comme il a été décrit précédemment. Ces aimants sont en samarium-cobalt, ont une longueur de 20 mm, et un diamètre de 20 mm. La longueur occupée par les aimants, dans ce cas 240 mm, constitue la zone active de l'antenne. Cette longueur peut être modifiée en changeant le nombre d'aimants, et n'est pas critique. La puissance micro-onde est amenée sur l'antenne par un passage coaxial d'impédance 50 ohms. Avec un tel dispositif, le plasma peut être généré dans une atmosphère d'argon à des pressions de quelques $10^{-5}$mbar.

L'invention concerne, de façon plus générale, une antenne présentant au moins une portion tubulaire, le tube ayant par exemple la forme d'un anneau, ou d'un tore, ou d'une boucle. Il peut également être disposé sous la forme d'une hélice. Le tube est disposé le long d'un axe, ou définit un axe. A l'intérieur de ce tube, des aimants ou des bobines électromagnétiques sont disposés le long de cet axe.

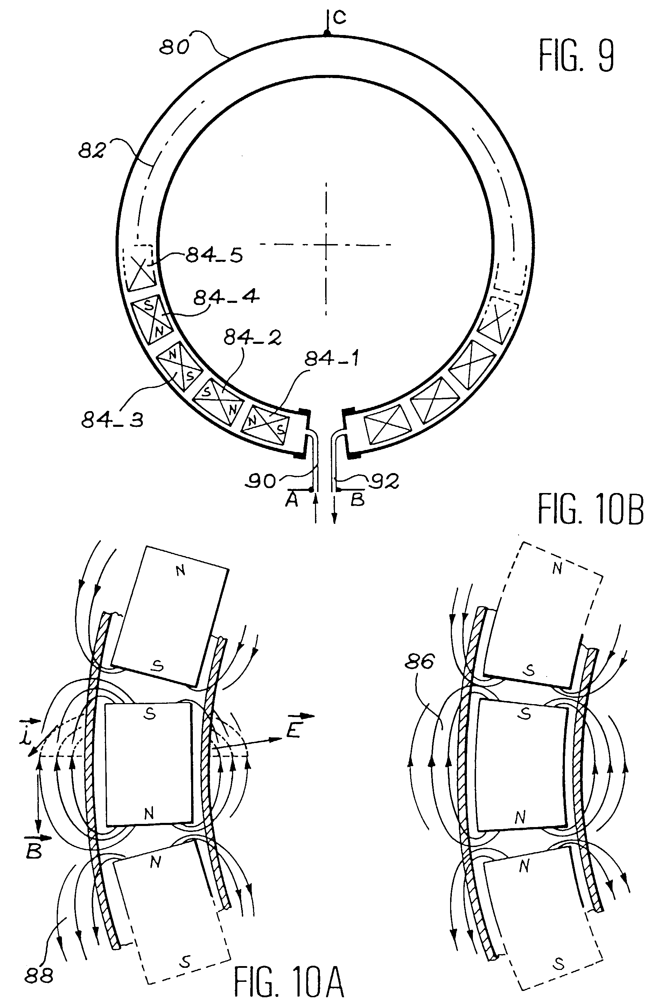

Un exemple de réalisation est donné sur la figure 9, où la référence 80 désigne un tube qui définit globalement la forme d'un anneau, ou d'une boucle. Ce tube a, par exemple, une section circulaire constante, auquel cas il est essentiellement de forme torique. Il est possible de définir un axe 82 à l'intérieur du tube. Le long de cet axe 82 sont disposés des moyens 84-1, 84-2, 84-3,... qui permettent d'engendrer un champ magnétique au voisinage du tube 80. Ces moyens peuvent être des aimants permanents ou des bobines électromagnétiques. Sur la figure 9, on a représenté des aimants. Chaque aimant est séparé de chacun de ses voisins par une distance de l'ordre de, par exemple, quelques millimètres ; la séparation est assurée, par exemple, par une petite cale en un matériau amagnétique. Les pôles de ces aimants sont sur des faces sensiblement perpendiculaires à l'axe du cylindre, et les aimants sont disposés de façon à ce que les pôles en regard de deux aimants immédiatement voisins (par exemple 84-2 et 84-3) soient de même signe.

La disposition de trois aimants consécutifs est représentée de manière plus détaillée sur les figures 10A et 10B. Sur la figure 10A, les aimants sont des aimants cylindriques. L'homme du métier saura les choisir d'une taille telle qu'il y ait suffisamment de jeu pour les introduire dans le tube correspondant. Les aimants peuvent être placés dans une gaine souple, cette gaine étant ensuite introduite dans l'antenne de forme tubulaire.

Sur la figure 10B, les aimants sont de forme tronctorique et ils ont la même courbure que la portion tubulaire de l'antenne dans laquelle ils sont introduits.

Dans tous les cas, on obtient une configuration de champ magnétique qui a, comme dans le cas illustré sur la figure 5, une structure approximativement en chevron entourant l'antenne. Le fait de mettre des aimants dans l'antenne a pour conséquence que celle-ci se trouve immédiatement dans la zone où l'intensité du champ magnétique est favorable à la résonance cyclotronique-électronique. Là encore, le champ $\vec{E}$ est radial, et la zone de résonance est constituée d'anneaux 86, 88 entourant l'antenne. Par conséquent, là encore, le volume de l'espace où a lieu la résonance est supérieur au volume obtenu avec les dispositifs connus de l'art antérieur. Les champs magnétique B et électrique E sont essentiellement perpendiculaires entre eux et le transfert d'énergie est maximum dans ce volume.

Du fait de la courbure de l'antenne, on ne peut plus dire, strictement, que les lignes de champ magnétique sont dans des plans passant par l'axe du tube. Cependant, c'est encore vrai, de manière approximative. Il en résulte que le courant $\vec{i}$ de dérive du plasma est toujours, à chaque instant, contenu dans un plan perpendiculaire à l'axe du tube 80 (ou, de manière équivalente, dans un plan définissant la section de ce tube) . Ce courant va donc décrire approximativement un cercle centré sur l'antenne, ce qui n'entraîne aucune inhomogénéité du plasma.

L'antenne représentée sur la figure 9 a la forme globale d'un anneau, ou d'un tore. Il est clair que l'enseignement de l'invention ne se limite pas à cette forme d'une portion tubulaire. Cette dernière peut également présenter, par exemple, un axe disposé le long d'une hélice, avec les mêmes empilements d'aimants ou de bobinages électromagnétiques. L'antenne peut aussi avoir la forme d'un tube incurvé, par exemple obtenu par courbure à partir de la forme cylindrique droite de la figure 5.

Toutes ces antennes fonctionnent avec les mêmes propriétés et avantages que l'antenne droite décrite ci-dessus en liaison avec la figure 5 : seule la courbure varie.

Sur la figure 9, les conduits 90, 92 désignent des conduits d'arrivées et de départ de liquide ou fluide de refroidissement, ou liquide ou fluide caloporteur. A l'intérieur du tube 80, ce liquide circulera le long des aimants, ou des bobines magnétiques. Il peut aussi, en plus ou de manière alternative, circuler à l'intérieur d'un tube, non représenté sur la figure 9, qui traverse tous les aimants, de manière équivalente au tube 58 de la figure 7B.

Dans un circuit tel que celui illustré sur la figure 9, l'introduction de l'énergie micro-onde peut être réalisée, par exemple, entre les points A et B, l'un de ces points étant relié à la masse. On peut, de manière alternative, relier les points A et B à la masse et réaliser l'introduction de l'énergie entre les points C et A. Une prise coaxiale, non représentée, peut par exemple permettre d'assurer la connexion à une alimentation électrique micro-onde.

Le domaine d'application de l'antenne suivant l'invention est la production de plasma. Elle pourra ainsi être utilisée dans tous les systèmes utilisant les plasmas (dépôt par pulvérisation cathodique, assistance ionique pendant un dépôt, PECVD, gravure ionique, source d'ions, sources de radicaux, etc...).

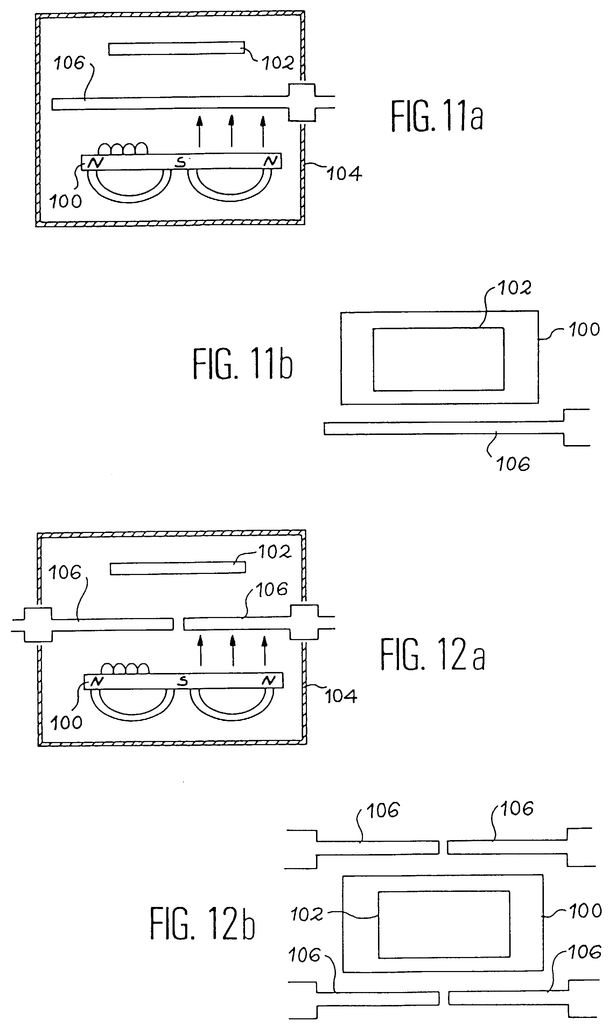

Un exemple d'application à la réalisation de micropointes va être décrit en liaison avec les figures 11a, 12a, et 11b, 12b.

Sur ces figures, sont représentés un magnétron source de vapeur 100 ; un substrat 102 ; une enceinte à vide 104 ; une ou plusieurs antennes 106.

C'est sur le substrat qu'est réalisé le dépôt de micropointes.

Industriellement, des magnétrons de plusieurs mètres de long existent (par exemple pour des dépôts sur vitrages au défilé). On peut ainsi envisager des dépôts au "défilé" sur des écrans de grandes dimensions, ou sur plusieurs écrans de plus petites dimensions juxtaposés.

On utilise un système d'assistance de magnétron par une décharge micro-ondes afin de générer directement le plasma à basse pression ($10^{-5}$ mb) sans adjonction de gaz. Les électrons du plasma sont piégés autour de la ou des antennes micro-ondes à l'aide d'un champ magnétique et leur efficacité est augmentée par l'effet de résonance cyclotronique électronique.

Cet effet de résonance est obtenue par exemple avec un champ magnétique de $875 \cdot 10^{-4}$ T combiné à un champ électrique de fréquence 2,45 GHz.

Une mise en oeuvre de l'invention est par exemple obtenue en considérant les différentes étapes (1) à (9) mentionnées dans l'introduction à la présente demande et en y remplaçant les étapes qui mettent en oeuvre l'évaporation sous vide par la technique d'évaporation par magnétron assisté par plasma, ce dernier étant engendré à l'aide d'une antenne selon l'invention.

Par conséquent, à l'aide d'une ou de plusieurs antennes selon l'invention, on peut produire une décharge micro-onde, dans des conditions de résonance cyclotronique électronique, cette décharge générant et entretenant un plasma basse-pression. Ce dernier est utilisé comme système d'assistance à un magnétron, à la surface duquel il permet d'envoyer des électrons. On peut ainsi utiliser le magnétron à pression plus basse et, donc, rendre le flux de vapeur directif.

Les variantes de l'invention permettent de conserver les avantages de pulvérisation cathodique magnétron, à savoir :

- possibilité de traiter des substrats de grande dimension,
- choix infini au niveau des matériaux.

Pour réaliser ces dépôts, il est possible d'utiliser des cibles de la composition souhaitée, par exemple une cible de $Cr_3C_2$, ou de réaliser les dépôts en mode réactif, c'est-à-dire en partant d'une cible de Cr pur et en injectant dans le plasma froid sur hydrocarbure (par exemple en $C_2H_2$-$CH_4$) pendant la phase de dépôt.

Cette technique s'apparentant au P.V.D (Physical Vapor Deposition) et C.V.D. (Chemical Vapor Deposition) permet l'obtention de composés impossibles à réaliser d'une manière classique : il est ainsi possible d'élaborer des revêtements sursaturés en carbone non décrits par la thermodynamique classique.

Cette technique permet de régler, d'ajuster la stoechiométrie des composés, par exemple en MoCx, CrCx, TiCx, TaCx... en faisant soit des solutions sursaturées, soit des carbures intermédiaires, par exemple $Mo_2C$, ou des carbures plus chargés en carbone, par exemple MoC. On peut également élaborer des revêtements contenant plus de carbone que les composés décrits dans la littérature. L'élaboration de nitrures, par exemple MoNx, TiNx, CrNx, TaNx ou de carbonitrures est possible en introduisant des mélanges de gaz réactifs dans le plasma (par exemple CxHy et $N_2$). L'introduction de gaz oxydants (par exemple $O_2$) est également possible : on peut ainsi élaborer des oxycarbures ou nitrures.

Les composés, selon les conditions d'élaboration : température de substrat, pression de gaz réactif, polarisation des substrats, peuvent être amorphes, monocristallins ou très bien cristallisés.

Cette technique permet notamment l'élaboration de carbone de type diamant en utilisant des cibles en graphite et en incorporant dans le plasma des composés type CxHy, $H_2$...

Ces revêtements peuvent de plus être dopés par du bore ou du phosphore en utilisant par exemple des gaz réactifs dans le plasma (par exemple diborane, phosphine, $PH_3$).

## Revendications

1. Antenne micro-onde, caractérisée en ce qu'elle comporte au moins une portion tubulaire (20, 80) présentant un axe central (82), des aimants (22-1, 22-2, ..., 84-1, 84-2,...), ou bien des bobines électromagnétiques, étant disposé(e)s à l'intérieur de la portion tubulaire, le long de l'axe central, pour générer un champ magnétique au voisinage de l'antenne, chaque extrémité de chaque aimant étant en regard d'une extrémité de même polarité d'un aimant immédiatement voisin, ou bien l'enroulement de chaque bobine étant tel que, lorsque la bobine est activée, chacune de ses extrémités est en regard d'une d'extrémité de même polarité d'une bobine immédiatement voisine.

2. Antenne selon la revendication 1, des bobines électromagnétiques étant disposées à l'intérieur de la portion tubulaire, le fil des bobines étant supraconducteur.

3. Antenne micro-onde selon l'une des revendications 1 ou 2, la portion tubulaire (20) étant une portion cylindrique creuse, les aimants (22-1, 22-2,...), ou bobines, étant empilé(e)s dans cette portion cylindrique, les lignes (24) du champ magnétique engendré étant alors essentiellement dans des plans parallèles aux génératrices de la portion cylindrique.

4. Antenne selon la revendication 3, comportant au moins deux portions cylindriques creuses (64, 66), chacune contenant des moyens pour générer un champ magnétique au voisinage de l'antenne (68-1, 68-2, 68-3, ..., 70-1, 70-2, 70-3), les lignes du champ magnétique engendré au voisinage de chaque portion étant essentiellement dans des plans parallèles aux génératrices de ladite portion cylindrique.

5. Antenne selon l'une des revendications 1 ou 2, la portion tubulaire (80) ayant une forme d'anneau ou de tore.

6. Antenne selon l'une des revendications 1 ou 2, la portion tubulaire ayant la forme d'une hélice.

7. Antenne selon l'une des revendications précédentes, comportant en outre des moyens (48, 50, 52, 54, 58, 60, 90, 92) de circulation d'un fluide caloporteur.

8. Procédé d'élaboration de micropointes, à composition contrôlée, sur de grandes surfaces, utilisant une technique de pulvérisation cathodique de type magnétron, une décharge micro-onde, produite par une ou plusieurs antennes micro-ondes (106) selon l'une des revendications précédentes, générant et entretenant un plasma basse pression, permettant d'envoyer des électrons à la surface du magnétron.

9. Procédé selon la revendication 8, des cibles de composition souhaitée étant utilisées sur lesquelles on réalise des dépôts en mode réactif.

10. Procédé selon l'une des revendications 8 ou 9, la réalisation de micropointes sur de grandes surfaces se faisant "au défilé".

**Patentansprüche**

1. Mikrowellenantenne, **dadurch gekennzeichnet**, daß sie wenigstens ein röhrenförmiges Stück (20, 80) umfaßt, das eine Mittelachse (82), Magnete (22-1, 22-2, ..., 84-1, 84-2,...) oder auch elektromagnetische Spulen umfaßt, angeordnet im Innern des röhrenförmigen Stücks, längs der Mittelachse, um in der Umgebung der Antenne ein elektromagnetisches Feld zu erzeugen, wobei jedes Ende jedes Magneten einem Ende derselben Polarität eines unmittelbar benachbarten Magneten gegenübersteht, oder auch die Wicklung jeder Spule derartig ist, daß, wenn die Spule aktiviert wird, jedes ihrer Enden einem Ende derselben Polarität einer unmittelbar benachbarten Spule gegenübersteht.

2. Antenne nach Anspruch 1, wobei im Innern des röhrenförmigen Stücks elektromagnetische Spulen angeordnet sind und dabei der Draht der Spulen supraleitend ist.

3. Antenne nach einem der Ansprüche 1 oder 2, wobei das röhrenförmige Stück (20) ein hohles zylindrisches Stück ist, die Magnete (22-1, 22-2,...) oder Spulen in diesem zylindrischen Stück gestapelt sind und die erzeugten Magnetfeldlinien (24) dann im wesentlichen in zu den Mantellinien des zylindrischen Stücks parallelen Ebenen verlaufen.

4. Antenne nach Anspruch 3, die wenigstens zwei hohle zylindrische Stücke (64, 66) umfaßt, von denen jedes Einrichtungen zum Erzeugen eines Magnetfelds in der Umgebung der Antenne (68-1, 68-2, 68-3, ..., 70-1, 70-2, 70-3) enthält, wobei die in der Umgebung jedes Stücks erzeugten Magnetfeldlinien im wesentlichen in zu den Mantellinien des besagten zylindrischen Stücks parallelen Ebenen verlaufen.

5. Antenne nach einem der Ansprüche 1 oder 2, wobei das röhrenförmige Stück (80) die Form eines Rings oder Torus hat.

6. Antenne nach einem der Ansprüche 1 oder 2, wobei das röhrenförmgie Stück die Form einer Schnecke bzw. Wendel hat.

7. Antenne nach einem der vorangehenden Ansprüche, die außerdem Zirkulationseinrichtungen (48, 50, 52, 54, 58, 60, 90, 92) eines Wärmeübertragungsfluids umfaßt.

8. Herstellungsverfahren von Mikropunkten mit kontrollierter Zusammensetzung auf großen Flächen durch Anwendung einer Sputtertechnik des Magnetrontyps, wobei eine Mikrowellenentladung, erzeugt durch eine oder mehrere Mikrowellenantennen (106) nach einem der vorangehenden Ansprüche, ein Niedrigdruck-Plasma erzeugt und aufrechterhält, das Elektronen auf die Oberfläche des Magnetrons sendet.

9. Verfahren nach Anspruch 8, wobei Targets mit gewünschter Zusammensetzung benutzt werden, auf denen man Abscheidungen der reaktiven Art herstellt.

10. Verfahren nach einem der Ansprüche 8 oder 9, wobei die Herstellung der Mikropunkte auf großen Flächen "im Defilee" bzw. im kontinuierlichen Durchlauf erfolgt.

## Claims

1. Microwave antenna, characterized in that it comprises at least one tubular portion (20, 80) having a central axis (82), magnets (22-1, 22-2, ...., 84-1, 84-2, ...) or electromagnetic coils, being placed within the tubular portion, along the central axis, in order to generate a magnetic field in the vicinity of the antenna, each end of each magnet facing one end having the same polarity of an immediately adjacent magnet, or the winding of each coil is such that, when the coil is activated, each of its ends faces one end having the same polarity of the immediately adjacent coil.

2. Antenna according to claim 1, electromagnetic coils being placed within the tubular portion, the wire of the coils being superconducting.

3. Microwave antenna according to either of the claims 1 and 2, the tubular portion (20) being a hollow, cylindrical portion, the magnets (22-1, 22-2, ...) or coils, being stacked in said cylindrical portion, the lines (24) of the magnetic field produced then being essentially in planes parallel to the generatrixes of the cylindrical portion.

4. Antenna according to claim 3, having at least two hollow, cylindrical portions (64, 66), each containing means for generating a magnetic field in the vicinity of the antenna (68-1, 68-2, 68-3, ... 70-1, 70-2, 70-3), the lines of the magnetic field produced in the vicinity of each portion being essentially in planes parallel to the generatrixes of said cylindrical portion.

5. Antenna according to either of the claims 1 and 2, the tubular portion (80) being shaped like a ring or torus.

6. Antenna according to one of the claims 1 or 2, the tubular portion being shaped like a helix.

7. Antenna according to one of the preceding claims, also having means (48, 50, 52, 54, 58, 60, 90, 92) for the circulation of a heat transfer fluid.

8. Process for the production of microtips, having a controlled composition and on large surfaces, using a magnetron cathodic sputtering procedure, a microwave discharge, produced by one or more microwave antennas (106) according to one of the preceding claims, generating and maintaining a low pressure plasma, so that electrons can be supplied to the magnetron surface.

9. Process according to claim 8, targets of the desired composition being used, on which depositions take place in the reactive mode.

10. Process according to either of the claims 8 and 9, the microtips being produced on large surfaces "on the move".

FIG. 1

FIG. 2

FIG. 3 a

FIG. 3 b

FIG. 3 c

FIG. 3 d

FIG. 3 e

FIG. 3 f

FIG. 4

FIG. 5

FIG. 6

FIG. 7a

FIG. 7b

FIG. 8

FIG. 9

80

82

84_5
84_4
84_2
84_1

84_3

90        92

A        B

C

FIG. 10B

86

88

FIG. 10A

FIG. 11a

FIG. 11b

FIG. 12a

FIG. 12b